# EUROPEAN PATENT APPLICATION

(11) **EP 4 851 653 A1**
(43) Date of publication of application: **09.12.2026**
(21) Application number: 25305813.5
(22) Date of filing: 04.06.2025
(51) Int. Cl.: G01R 33/00, H02K 17/16, G06F 30/20

(54) **METHOD AND SYSTEM FOR ESTIMATING ELECTRICAL PARAMETERS OF SQUIRREL CAGE INDUCTION MOTORS FROM MINIMAL INPUT DATA**

(71) Applicant: Schneider Toshiba Inverter Europe SAS, 27120 Pacy-sur-Eure (FR)
(72) Inventor: SAKR, Georges, 76130 MONT SAINT AIGNAN (FR); AWDE, Ahmad, 27200 VERNON (FR); TFAILY, Ali, 92500 RUEIL MALMAISON (FR); BENBERKANE, Sofiane, 78300 POISSY (FR); JEBAI, Al Kassem, 27200 VERNON (FR)
(74) Representative: Plasseraud IP

(57) **Abstract**

The present document relates to a method for estimating electrical parameters of a squirrel cage induction motor using a computing system, the method comprising:
- receiving (100) a specific set of input parameters for the squirrel cage induction motor, said specific set of input parameters comprising: number of phases (m); pole pairs (p); stator effective length (*l*); inner and outer diameter of the stator (*Ds, Dos);* rotor inner diameter (*Dr*)*;* number of effective turns per phase (*Ns*)*;* number of stator slots (*Qs*)*;* number of rotor bars (*Qr*)*;* and stator resistance (Rs);
- deriving (110) from said specific set of input parameters, one or more intermediate parameters; and
- estimating (120), based on said specific set of input parameters and the derived intermediate parameters, a set of output electrical parameters for the squirrel cage induction motor, said output electrical parameters comprising: an effective air gap ( *δef* ); a magnetizing inductance (*Lm*); at least one stator leakage inductance selected from the group consisting of slot leakage inductance (*Lu*)*,* end winding leakage inductance (*Lew*), and air gap leakage inductance (*Lδ*); and a rotor resistance (*Rr*).

## Description

### Technical Field

The present invention relates generally to the field of electrical motor diagnostics and predictive maintenance. More specifically, it pertains to a method and system for automatically estimating critical electrical parameters of squirrel cage induction motors using a minimal set of geometric and nameplate data, thereby facilitating advanced modeling, fault simulation, and the development of predictive maintenance algorithms and digital twins.

### Prior art

Squirrel cage induction motors are widely used in industrial applications. For effective predictive maintenance, advanced modeling, and the development of digital twins, accurate knowledge of various electrical parameters of these motors is useful. These parameters include, among others, magnetizing inductance, various leakage inductances (such as slot, end winding, and air gap leakage inductances), and rotor resistance components (bar and end ring resistance).

Traditionally, obtaining a comprehensive set of these parameters has been challenging. Motor manufacturers often do not provide all the necessary detailed parameters beyond basic nameplate data. The information available on the motor nameplate, such as rated power, voltage, current, and speed, is typically insufficient for sophisticated motor models that require a deeper understanding of the motor's internal electrical characteristics.

Alternative methods for parameter determination, such as extensive laboratory testing involving dedicated test benches or disassembly of the motor for direct measurement of geometric features (e.g., slot dimensions), are often costly, time-consuming, and impractical for large-scale industrial deployment or for motors already in service. These methods may also require specialized equipment and expertise, further limiting their accessibility.

Moreover, existing estimation techniques found in the literature might require a more extensive set of geometric inputs than is readily available or may rely on approximations that are not universally applicable across different motor designs and power ratings. For instance, while some empirical models or internal tools may exist for estimating certain parameters like stator resistance, their accuracy can vary significantly depending on the motor manufacturer.

There is therefore a need for an automated method that can accurately estimate a comprehensive set of critical electrical parameters for squirrel cage induction motors using only a minimal and easily obtainable set of input data, typically available from manufacturer specifications or basic nameplate information, without requiring extensive manufacturer data, physical test benches, or motor disassembly. Such a method would enable the generation of synthetic data for training Al models, improve the accuracy of predictive maintenance systems, and facilitate the creation of high-fidelity digital twins.

### Summary

To this aim, the present document proposes a computer-implemented method for estimating electrical parameters of a squirrel cage induction motor, the method comprising:
- receiving a specific set of input parameters for the squirrel cage induction motor, said specific set of input parameters comprising: number of phases (*m*); pole pairs (*p*); stator effective length (*l*); inner and outer diameter of the stator (*Ds,Dos*); rotor inner diameter (*Dr*); number of effective turns per phase (*Ns*); number of stator slots (*Qs*); number of rotor bars (*Qr*); and stator resistance (*Rs*);
- deriving from said specific set of input parameters, one or more intermediate parameters; and
- estimating, based on said specific set of input parameters and the derived intermediate parameters, a set of output electrical parameters for the squirrel cage induction motor, said output electrical parameters comprising: an effective air gap (*δef*); a magnetizing inductance (*Lm*); at least one stator leakage inductance selected from the group consisting of slot leakage inductance (*Lu*), end winding leakage inductance (*Lew*), and air gap leakage inductance (*Lδ*); and a rotor resistance (*Rr*).

The expression "computer-implemented method" designates a method wherein all steps are executed by one or more processors within a computing system, such as a personal computer, a server, or an embedded system, based on a sequence of stored program instructions. This implies that the method is automated and relies on computational power for its execution.

The expression "estimating electrical parameters" designates the computational process of calculating or deducing the quantitative values of various electrical characteristics intrinsic to the operational behavior and electromagnetic model of an electrical machine. For instance, this includes determining values for inductances that describe magnetic energy storage, or resistances that characterize energy dissipation.

The term "squirrel cage induction motor" designates a widely used type of alternating current (AC) asynchronous motor where the rotor is constructed with conductive bars, typically made of aluminum or copper, embedded in slots and short-circuited at both ends by conductive end rings, forming a structure akin to a cage. This design eliminates the need for brushes or slip rings to supply current to the rotor, making it robust and low-maintenance.

The expression "receiving a specific set of input parameters" designates the action by which the computing system acquires or is actively provided with a pre-defined and minimal collection of fundamental data points. These data points allow initiating the entire estimation process and are typically sourced from manufacturer datasheets, nameplate information, or basic design specifications, without requiring exhaustive measurements or proprietary design files from the manufacturer.

The input parameter "number of phases (*m*)" designates the quantity of distinct alternating current (AC) power supplies that energize the stator windings of the motor, which is for example three for most industrial induction motors, providing a rotating magnetic field.

The input parameter "pole pairs (p)" designates half the total number of magnetic poles created by the stator winding arrangement; for example, a 4-pole motor has 2 pole pairs, and this value, along with the supply frequency, determines the motor's synchronous speed.

The input parameter "stator effective length (*l*)" designates the axial dimension of the stator laminated core that actively participates in the main magnetic flux path, excluding, for example, cooling ducts within the stack if they significantly interrupt the magnetic material.

The input parameters "inner and outer diameter of the stator (*Ds,Dos*)*"* designate the internal diametrical dimension of the stator core (bore diameter) and the external diametrical dimension of the stator core, respectively, which are fundamental geometric measures.

The input parameter "rotor inner diameter (*Dr*)" designates the internal diametrical dimension of the rotor core, relevant for mechanical considerations or if the rotor is hollow.

The input parameter "number of effective turns per phase (*Ns*)" designates the equivalent number of conductor turns connected in series for each phase of the stator winding, taking into account complex winding layouts and coil connections, and is a key factor in determining the motor's voltage and flux linkage.

The input parameter "number of stator slots (*Qs*)" designates the total quantity of indentations or channels machined into the inner periphery of the stator core, designed to house and secure the stator winding conductors.

The input parameter "number of rotor bars (*Qr*)" designates the total quantity of conductive bars that are part of the rotor's squirrel cage construction, running axially through the rotor core.

The input parameter "stator resistance (*Rs*)" designates the electrical DC resistance measured for each phase winding of the stator, usually specified at a standard reference temperature (e.g., 20°C or 25°C), as temperature significantly affects resistance.

The expression "deriving one or more intermediate parameters" designates the computational process by which the computing system calculates or determines numerical values for a set of secondary parameters. These intermediate parameters are not directly provided as inputs but are calculated using mathematical relationships based on the specific set of input parameters. They serve as building blocks or interim results that are subsequently used in the more complex calculations for estimating the final output electrical parameters. Examples include winding factors or specific permeance coefficients.

The expression "estimating a set of output electrical parameters" designates the final computational stage where the computing system calculates or deduces the values of a collection of electrical characteristics that define the motor's performance and behavior. This estimation is based comprehensively on the specific set of input parameters and the previously derived intermediate parameters, employing established electromagnetic principles and specific model equations.

The output parameter "effective air gap (*δef*)" designates the apparent magnetic distance, or reluctance path length, between the stator and rotor surfaces. This value is typically larger than the physical, mechanical air gap and accounts for the non-uniform magnetic field distribution caused by phenomena such as stator and rotor slot openings (Carter's coefficient), magnetic saturation in the iron core, and any geometric irregularities. It directly influences the calculation of magnetizing inductance and the density of the magnetic flux in the air gap.

The output parameter "magnetizing inductance (*Lm*)" designates the inductance component in the motor's equivalent circuit that represents the mutual magnetic flux linking both the stator and rotor windings through the main magnetic path, primarily across the air gap. This inductance is useful for establishing the working magnetic field of the motor and is directly related to the motor's ability to convert electrical energy into mechanical energy.

The term "stator leakage inductance" designates an inductance associated with the portion of magnetic flux generated by the current in a stator winding that does not cross the air gap to link with the rotor winding, and therefore does not contribute to the useful torque production. This leakage flux follows paths predominantly in air or within the stator iron itself, around the stator conductors.

The output parameter "slot leakage inductance (*Lu*)" designates the specific component of the total stator leakage inductance that arises from magnetic flux lines circulating around the stator conductors located within the confines of the stator slots themselves. Its magnitude depends on the geometry of the slots and the arrangement of conductors within them.

The output parameter "end winding leakage inductance (*Lew*)" designates the specific component of the total stator leakage inductance that is associated with the magnetic flux produced by, and circulating around, the portions of the stator windings that extend axially beyond the stator core. These portions, known as end windings or overhangs, are necessary to connect coils but their flux does not contribute to useful torque.

The output parameter "air gap leakage inductance (*Lδ*)", also sometimes referred to as harmonic leakage inductance, designates the component of stator leakage inductance that is attributed to space harmonic components of the air gap magnetomotive force (MMF) wave. These harmonic fluxes, while present in the air gap, do not link with the rotor in the same way as the fundamental component and thus represent a form of leakage.

The output parameter "rotor resistance (Rr)" designates the total effective electrical DC resistance of the squirrel cage rotor circuit, as viewed or referred to the stator side through the turns ratio squared. It is a parameter influencing the motor's torque-speed characteristic, starting torque, slip at a given load, and overall efficiency due to *I*²*R* losses in the rotor. This parameter typically includes the combined effect of the resistance of the rotor bars and the end rings.

An advantage of the present invention is its ability to accurately estimate a comprehensive set of critical electrical parameters for a specific, physical squirrel cage induction motor using only a minimal set of readily obtainable input parameters. Unlike prior art methods that often require extensive manufacturer data, which may not be available, or necessitate complex and costly physical test bench measurements or motor disassembly, the present invention significantly simplifies the data acquisition process. By relying on a specific set of pre-defined geometric and nameplate data, augmented where necessary by straightforward measurements on the physical motor as described above, the method reduces operational costs and time associated with motor characterization.

Furthermore, the method provides a significant improvement in the context of predictive maintenance and digital twin technologies. Traditional approaches are often hampered by the lack of detailed motor parameters. The present invention overcomes this limitation by enabling the accurate deduction of parameters such as effective air gap, various leakage inductances, and detailed rotor resistance components from basic motor geometry inputs. This allows for the creation of high-fidelity models of existing physical motors, even when detailed manufacturer specifications are incomplete. These accurate models, based on parameters derived from a real motor, are useful for precise fault simulation, the development of robust predictive algorithms, and the creation of accurate digital twins that can mirror the performance and health of the actual machine with high fidelity.

Another advantage lies in the method's capacity to generate accurate synthetic data. Because the estimated output parameters are derived from and correspond to a physical motor, they can be used to generate high-quality synthetic datasets for training machine learning models, particularly neural networks, for fault detection and predictive maintenance. This is a significant improvement over relying solely on limited real-world failure data or less accurate generalized motor models. The invention thus empowers users to develop more reliable Al-powered classifiers for motor fault detection, even for motor types where extensive historical data or detailed design information is scarce.

The reliance on a defined, minimal set of input parameters, as opposed to requiring detailed internal geometric measurements of features like slot shapes, also means the method can be applied to a wider range of motors from different manufacturers without needing proprietary design information. This universality and reduced dependency on inaccessible data represent a clear practical advantage over prior art techniques that might be tailored to specific motor designs or require information that manufacturers are unwilling to disclose.

The method as described herein is applied to a physical, real-world squirrel cage induction motor. At least one of the input parameters within the specific set of input parameters may be obtained through a direct or indirect measurement performed on said physical motor prior to the execution of the computational estimation steps. For example, stator resistance (Rs) can be determined by applying a known DC voltage and measuring the current through a stator winding, or geometric parameters can be measured if the motor is accessible. This initial step of acquiring data from a tangible motor ensures that the subsequent computer-implemented estimation process operates on data corresponding to an actual machine, thereby producing output electrical parameters that are representative of a concrete technical system. The estimation method thus provides a technical effect by yielding accurate parameters for a specific, existing motor, which can then be used for tangible technical purposes such as its improved control, predictive maintenance, or the creation of a high-fidelity digital twin of that particular physical motor.

While the method is described as receiving a specific set of input parameters, it is contemplated that certain parameters within this set, though treated as inputs for the core estimation process for maximal accuracy and broad applicability, may themselves be precalculated, pre-determined, or estimated prior to being formally received by the computing system for the main parameter estimation task. For example, the number of phases (m) is typically a known and evident characteristic of the motor (e.g., three phases for most industrial motors) and might be considered a fixed input. Similarly, the stator resistance (Rs) can, in some instances or for specific motor families, be estimated using tools or methods. However, to ensure robustness and precision across a wide variety of motor types and manufacturers (for which such internal estimations might be less accurate), and to provide a clearly defined starting point for the disclosed estimation method, the stator resistance (Rs) is preferably included as part of the specific set of input parameters formally received by the system. The core inventive method thus proceeds from this defined set of received inputs, irrespective of whether one or more of these inputs were, in a preliminary step not part of the core claimed method, themselves derived or measured. This approach ensures that the subsequent derivation of intermediate parameters and estimation of output parameters is based on a consistent and well-defined foundation.

The one or more intermediate parameters derived from said specific set of input parameters may comprise at least one selected from the group consisting of: a winding factor (*kw1*); a skewing factor (*ksq*1); a slot per pole per phase (*q*); a leakage factor of air gap inductance (*σδ*); permeance factors of windings (*λlew,λw*) and stator slot (*λu*); and a rotor bar length (*lbar*).

The intermediate parameter "winding factor (kw1)" for the fundamental component designates a coefficient, typically less than unity, that accounts for the spatial distribution and pitching of the stator winding coils. It reflects the extent to which the electromotive forces (EMFs) induced in individual coils add up vectorially due to the coils being distributed in multiple slots and potentially being short-pitched (i.e., coil span less than a full pole pitch). A precise winding factor is useful for accurately calculating inductances and induced voltages.

The intermediate parameter "skewing factor (*ksq*1)*"* for the fundamental component designates a coefficient, also typically less than unity, that accounts for the effect of skewing either the stator slots or, more commonly, the rotor bars. Skewing involves angling the slots or bars relative to the motor axis, and this factor quantifies the reduction in induced EMF and certain harmonic components, which is beneficial for reducing noise and torque ripple.

The intermediate parameter "slot per pole per phase (*q*)" designates the number of stator slots allocated to each phase under each magnetic pole. It is calculated from the total number of stator slots (*Qs*), the number of phases (*m*), and the number of pole pairs (p). This parameter is useful to the winding layout and influences various performance characteristics, including harmonic content and winding factors.

The intermediate parameter "leakage factor of air gap inductance (*σδ*)", also referred to as the air gap leakage coefficient, designates a dimensionless factor that quantifies the proportion of the air gap magnetomotive force (MMF) that does not contribute to the main mutual flux but instead results in leakage flux within the air gap, often due to winding harmonics. It is used in conjunction with the magnetizing inductance to determine the air gap leakage inductance.

The intermediate parameters "permeance factors of windings (*λlew,λw*) and stator slot (*λu*)" designate dimensionless coefficients that characterize the ease with which magnetic flux can pass through specific leakage paths. Specifically, *λlew* and *λw* relate to the permeance of paths associated with end winding leakage flux, considering their geometry outside the stator core. The stator slot permeance factor (*λu*) characterizes the permeance of leakage flux paths within and around the stator slots, depending on slot geometry and conductor arrangement. These factors are useful for calculating the respective leakage inductances.

The intermediate parameter "rotor bar length (*lbar*)" designates the effective axial length of a single rotor bar in the squirrel cage. This length may be greater than the stator effective length (*l*) if the rotor bars are skewed, as skewing increases their path length. It is a key geometric parameter for calculating rotor resistance and rotor leakage inductances.

The derivation of these specific intermediate parameters from the minimal set of input parameters bridges the gap between easily available input data and the complex parameters needed for accurate output estimation. It allows the method to model nuanced electromagnetic phenomena, like the effects of winding distribution and skewing, without explicitly requiring these detailed design choices as inputs, thus enhancing the accuracy of the final estimated output electrical parameters (such as specific leakage inductances and resistances) compared to methods that might use more generalized or assumed values for these intermediate effects. This, in turn, leads to more reliable motor models for predictive maintenance and digital twin applications.

The set of output electrical parameters estimated based on said specific set of input parameters and the derived intermediate parameters may further comprise at least one selected from the group consisting of: stator and rotor leakage inductances (*Lls,Llr);* stator and rotor total inductances (*Ls,Lr*); bar leakage inductance (*Lb*); and end ring leakage inductance (*Le*)*.*

The output parameters "stator and rotor leakage inductances (*Lls,Llr*)" designate the inductances associated with magnetic flux components that do not contribute to the mutual flux linkage between the stator and rotor. Specifically, stator leakage inductance (*Lls*) encompasses all leakage flux paths associated with the stator winding (such as slot, end winding, and air gap leakage as previously defined or further refined). Rotor leakage inductance *(Llr),* as referred to the stator, represents the leakage flux associated with the rotor winding (the squirrel cage), which similarly does not link with the stator winding and primarily influences the rotor's current and transient behavior.

The output parameters "stator and rotor total inductances (*Ls,Lr*)" designate the overall inductances for the stator and rotor circuits, respectively, as seen from their terminals. The stator total inductance (*Ls*) for one phase is typically the sum of the magnetizing inductance *(Lm)* and the stator leakage inductance (*Lls*)*.* Similarly, the rotor total inductance (*Lr*), as referred to the stator, is the sum of the magnetizing inductance (*Lm,* as seen from the rotor side) and the rotor leakage inductance *(Llr).* These total inductances are useful for analyzing the motor's transient and steady-state performance in circuit models.

The output parameter "bar leakage inductance (*Lb*)" designates the component of the rotor leakage inductance that is specifically associated with the magnetic flux circulating around an individual rotor bar within its slot and partially in the surrounding iron. This parameter is udeful for accurately modeling the distribution of current within the rotor bars, especially under conditions of varying frequency (slip).

The output parameter "end ring leakage inductance (*Le*)" designates the component of the rotor leakage inductance that is specifically associated with the magnetic flux circulating around the end rings of the squirrel cage rotor. The end rings short-circuit the rotor bars, and the flux linked with these rings contributes to the overall rotor leakage.

These supplementary parameters enable a more detailed and precise representation of the motor's electromagnetic behavior. For instance, distinguishing between *Lls* and *Llr* allows for a more accurate simulation of both stator and rotor transients. Estimating *Lb* and *Le* provides deeper insight into the rotor circuit's characteristics, which is particularly valuable for diagnosing rotor-related faults (e.g., broken rotor bars) or for optimizing motor design for specific performance criteria. The availability of total inductances (*Ls,Lr*) simplifies the construction of complete equivalent circuit models used in drive control design and dynamic performance studies. Therefore, by extending the estimation to include these parameters, the invention offers a more comprehensive characterization of the physical motor, enhancing the fidelity of digital twins and the diagnostic capabilities of predictive maintenance systems beyond what would be possible with a more limited set of parameters. This enhanced detail, derived from the same minimal set of input data, underscores the efficiency and power of the disclosed estimation method.

The rotor resistance (*Rr*) estimated based on said specific set of input parameters and the derived intermediate parameters may comprise bar resistance (*rb*) and end ring resistance (*re*)*.*

The component "bar resistance (*rb*)" designates the electrical DC resistance of a single conductive bar within the squirrel cage rotor. This resistance is determined by the material (e.g., aluminum or copper), cross-sectional area, and effective length of the rotor bar. It is a primary contributor to the *I*²*R* losses occurring directly within the rotor bars during motor operation.

The component "end ring resistance (*re*)" designates the electrical DC resistance of a segment of one of the end rings of the squirrel cage rotor. The end rings serve to short-circuit all the rotor bars at both ends of the rotor core. The resistance of these rings, or segments thereof associated with each bar connection, contributes to the overall rotor circuit resistance and associated *I*²*R* losses.

While the total rotor resistance (*Rr*) is useful for overall performance modeling, distinguishing between *rb* and *re* allows for a more precise localization of heat generation within the rotor structure. This detailed understanding is particularly beneficial for advanced thermal modeling, predicting hotspots, and for diagnosing specific types of rotor faults. For example, a change in bar resistance (*rb*) could indicate issues like a cracked or broken rotor bar, while changes related to end ring resistance (*re*) might point to problems with the end ring integrity or the bar-to-end-ring connections. By providing this finer granularity in the estimation of rotor resistance components, derived from the same minimal set of input data, the invention enhances the diagnostic power and the fidelity of physical motor models used in sophisticated predictive maintenance strategies and for detailed performance optimization.

The method according to any of the preceding claims, wherein the estimation of said set of output electrical parameters is based at least in part on a Modified Winding Function Method (MWFM).

The term "Modified Winding Function Method (MWFM)" designates a known analytical or semi-analytical technique used for the calculation of inductances in electrical machines, particularly induction motors. This method is an advancement or adaptation of the classical Winding Function Method (WFM). The WFM itself determines machine inductances by considering the spatial distribution of stator and rotor windings and the geometry of the air gap. The MWFM typically incorporates refinements to account for complex phenomena such as stator and rotor slotting effects, magnetic saturation, or skewing with greater accuracy than the basic WFM, often by modifying the winding functions themselves or the way permeance variations are handled. It allows for the calculation of self and mutual inductances, including main magnetizing inductances and various leakage inductances, based on the motor's geometric design and winding layout.

The MWFM is recognized for its capability to accurately model the magnetic field distribution and inductance characteristics of electrical machines by taking into account detailed geometric features and winding arrangements. By employing such a method, the present invention can achieve a higher fidelity in the estimated parameters, such as magnetizing and leakage inductances, compared to simpler analytical formulas or purely empirical approaches. This is because the MWFM inherently considers the physical basis of inductance formation within the motor structure. The use of an MWFM, even if adapted or forming part of the underlying calculation engine, allows the overall estimation process to yield parameters that are more consistent with the actual electromagnetic behavior of the physical motor, which is useful for developing reliable predictive maintenance models and accurate digital twins. This approach contributes to the invention's ability to derive a comprehensive and precise set of parameters from the minimal input set, as the MWFM provides a robust framework for translating geometric and winding information into inductance values.

The method according to any of the preceding claims, may further comprising using the estimated set of output electrical parameters to support at least one of: advanced modeling of the induction motor; fault simulation for the induction motor; predictive algorithm development for maintenance of the induction motor; or development of a digital twin of the induction motor.

The term "advanced modeling of the induction motor" designates the creation and utilization of sophisticated mathematical representations or simulations of the squirrel cage induction motor that go beyond simple equivalent circuits. Such models aim to accurately capture complex electromagnetic, thermal, and mechanical behaviors, often incorporating non-linearities, spatial harmonics, and detailed parameter dependencies. These advanced models are used for in-depth performance analysis, design optimization, and control strategy development.

The term "fault simulation for the induction motor" designates the process of using a motor model to emulate the behavior of the induction motor under various fault conditions, such as broken rotor bars, stator winding inter-turn shorts, bearing faults, or eccentricity. By inputting fault characteristics into the model, engineers can study the signatures of these faults in measurable quantities (e.g., currents, vibrations, fluxes) to develop and validate fault detection and diagnostic techniques.

The term "predictive algorithm development for maintenance of the induction motor" designates the design, training, and implementation of computational algorithms, often based on machine learning or statistical methods, that analyze real-time or historical operational data from an induction motor to predict impending failures or the remaining useful life of its components. This allows maintenance to be scheduled proactively, minimizing unplanned downtime and optimizing resource allocation.

The term "development of a digital twin of the induction motor" designates the creation of a dynamic, virtual representation of a specific physical squirrel cage induction motor. This digital twin may be continuously updated with data from its physical counterpart and uses complex models (often informed by the estimated parameters) to simulate its behavior, performance, and health status in real-time, enabling advanced monitoring, diagnostics, prognostics, and what-if scenario analysis throughout the motor's lifecycle.

More particularly, one primary and highly impactful downstream application is enhanced predictive maintenance. The estimated parameters, such as detailed rotor resistance components (*rb, re*) and specific leakage inductances (*Lu, Lew, Lδ, Lb, Le*), allow for the creation of high-fidelity models of the specific motor. These models can then be used to:
- Improve fault detection sensitivity: By knowing the healthy baseline parameters of a specific motor, deviations detected during operation (e.g., changes in current signatures, temperature, or vibration patterns) can be more accurately correlated to incipient faults. For instance, an increase in estimated rotor resistance Rr, particularly if models can link it to an increase in *rb,* can strongly indicate broken rotor bars before catastrophic failure. This allows for targeted inspection and repair.
- Refine Remaining Useful Life (RUL) predictions: Algorithms predicting RUL benefit immensely from accurate motor parameters. For example, thermal models using precise stator (Rs) and rotor (Rr) resistances can better estimate heat generation and insulation degradation rates, leading to more reliable RUL estimations for the windings.
- Optimize maintenance scheduling: Instead of relying on fixed time-based maintenance or reacting to failures, maintenance interventions can be scheduled precisely when needed, based on the predicted health status derived from models using the estimated parameters. This means a specific motor identified as having degrading parameters (e.g., increasing leakage inductance suggesting winding issues) can be scheduled for overhaul, while other healthy motors continue operation, thus optimizing resource allocation and minimizing unnecessary downtime and costs.

Another concrete application is the optimization of motor control strategies. Modern variable speed drives (VSDs) often employ sophisticated control algorithms (e.g., field-oriented control, direct torque control) that rely on accurate motor parameters for optimal performance, efficiency, and dynamic response :
- Auto-tuning and commissioning of VSDs: The estimated parameters (*Lm, Ls, Lr, Rr, Rs*) can be directly fed into the auto-tuning routines of VSDs, or used to manually configure drive parameters for a specific motor for which such data was previously unavailable. This leads to improved torque control, reduced energy consumption, and smoother operation, directly impacting the physical behavior of the motor.
- Sensorless control improvement: Many sensorless control schemes estimate speed or rotor position based on motor models. The accuracy of these schemes is highly dependent on the accuracy of *Lm, Rr,* and leakage inductances. Using the parameters estimated by the present invention can significantly enhance the stability and precision of sensorless control, especially at low speeds or during transient conditions.
- Efficiency optimization: Drives can adjust voltage and frequency to operate the motor at its peak efficiency point for a given load. This requires an accurate loss model, which in turn depends on correct values for *Rs,Rr,* and inductances that influence iron losses. The estimated parameters enable the VSD to more effectively minimize energy losses in the physical motor.

The development and deployment of high-fidelity Digital Twins also represent a significant downstream application with tangible benefits. A digital twin, continuously updated with operational data and using the accurate estimated parameters as its foundation, can:
- Enable "what-if" scenario analysis for operational changes: Before physically changing a process that affects motor load, the digital twin can simulate the impact on the motor's performance, temperature, and stress levels, preventing potential damage or inefficiencies in the real motor.
- Support remote diagnostics and troubleshooting: Experts can analyze the behavior of a physical motor remotely via its digital twin, using the accurate parameters to diagnose issues without needing to be on-site immediately, leading to faster problem resolution.
- Optimize system-level performance: If multiple motors are part of a larger system, their interconnected digital twins (based on accurately estimated individual parameters) can be used to optimize the overall system's energy consumption or throughput by coordinating their operation.

Furthermore, in the context of motor design modification or retrofitting, if a motor needs to be adapted for a new application or if its performance needs to be slightly altered (e.g., by changing drive parameters or minor mechanical adjustments), having an accurate set of its existing electrical parameters, as provided by this invention, is invaluable. It allows engineers to predict the outcome of such modifications on the actual motor with greater confidence before committing to physical changes.

In summary, the method's ability to provide accurate electrical parameters from minimal data directly translates into improved physical operation of induction motors through more precise control, reduced energy consumption, proactive and targeted maintenance actions that prevent physical failures, and the ability to safely explore operational optimizations via digital simulations that accurately reflect the real machine. The benefits are therefore not merely informational but lead to tangible improvements in reliability, efficiency, and cost-effectiveness of industrial operations involving these motors.

Thus, method may further comprise:
- controlling the operation of said physical squirrel cage induction motor using a variable speed drive (VSD), wherein at least one control parameter of said VSD is determined or adjusted based on at least one of the estimated output electrical parameters; or
- performing a maintenance action on said physical squirrel cage induction motor, wherein the decision to perform said maintenance action, or the nature of said maintenance action, is determined based on an analysis of the condition of said motor, said analysis utilizing at least one of the estimated output electrical parameters to model or assess said condition; or
- modifying an operational characteristic or a maintenance schedule of said physical squirrel cage induction motor, wherein said modification is determined based on an assessment utilizing at least one of the estimated output electrical parameters; or
- providing said estimated set of output electrical parameters to a motor control system or a predictive maintenance system; and said motor control system or said predictive maintenance system subsequently initiating an action affecting said physical squirrel cage induction motor or its operational environment based on said estimated parameters.

The present document also relates to a system for estimating electrical parameters of a squirrel cage induction motor, the system comprising:
- an input interface configured to receive a specific set of input parameters for the squirrel cage induction motor, and
- a memory communicatively coupled to the processor, the memory storing instructions that, when executed by the processor, cause the system to perform the above-mentioned method.

The term "system" in this context designates an assembly of interconnected hardware components, potentially including software, configured to operate together to perform the specific task of estimating electrical parameters of a squirrel cage induction motor. This system may be a standalone device, integrated into a larger diagnostic or control apparatus, or implemented on a general-purpose computing platform.

The term "input interface" designates a component or a set of components within the system that is specifically designed and configured to receive or acquire the specific set of input parameters for the squirrel cage induction motor. This interface can take various forms, such as a user interface for manual data entry, a network interface for receiving data from external databases or sensors, a port for connecting to data storage devices, or an application programming interface (API) for interaction with other software modules.

The term "memory" designates any type of non-transitory computer-readable storage medium or media, communicatively coupled to the processor, capable of storing digital information, including program instructions and data. This can include volatile memory such as Random Access Memory (RAM) used for temporary storage during execution, and non-volatile memory such as Read-Only Memory (ROM), flash memory, hard disk drives, or solid-state drives used for persistent storage of the operating system, application programs, and the instructions for performing the estimation method.

The term "processor" designates one or more central processing units (CPUs), microprocessors, digital signal processors (DSPs), application-specific integrated circuits (ASICs), field-programmable gate arrays (FPGAs), or other programmable digital logic devices capable of executing program instructions. The processor is the primary component responsible for carrying out the computations and logical operations defined by the stored instructions to implement the estimation method.

The term "instructions" designates a set of computer-executable commands or code, stored in the memory, that, when retrieved and executed by the processor, direct the processor to perform the specific sequence of operations constituting the method for estimating electrical parameters as described in the preceding claims. These instructions embody the logic and algorithms of the estimation process.

The present document also relates to a computer program product comprising instructions which, when the program is executed by a computer, cause the computer to carry out the above-mentioned method.

The present document also relates to a non-transient computer-readable storage medium storing instructions thereon that, when executed by one or more processors, cause the one or more processors to perform the above-mentioned method.

### Brief description of the drawings

Other features, details and advantages will become apparent from the detailed description below, and from an analysis of the attached drawings, in which:
Fig. 1 is a schematic block diagram illustrating general steps of an embodiment of the method for estimating electrical parameters of a squirrel cage induction motor according to the present document.
Fig. 2 is a schematic block diagram illustrating an embodiment of a system configured to implement the method for estimating electrical parameters according to the present document.

### Detailed description of the drawings

The present invention provides a computer-implemented method and system for accurately estimating a comprehensive set of critical electrical parameters for a physical squirrel cage induction motor.

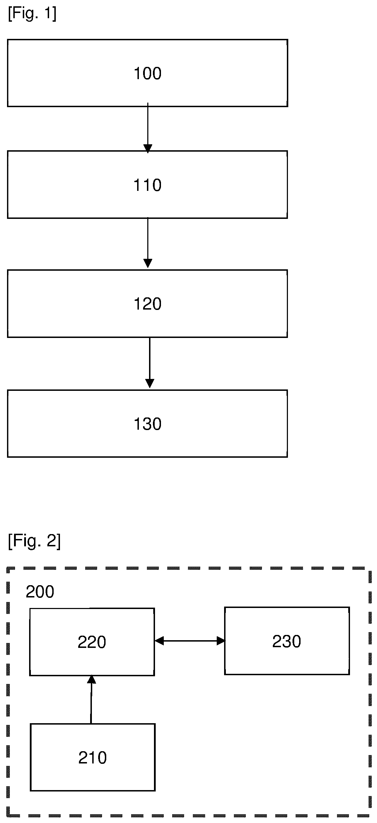

Referring now to Fig. 1, a schematic block diagram illustrating the general steps of an embodiment of the method for estimating electrical parameters is shown. The method begins with a first step of input parameters acquisition 100. In this step, the computing system receives a specific set of input parameters for the squirrel cage induction motor under consideration. As previously defined, this specific set comprises at least: the number of phases (*m*), the number of pole pairs (*p*), the stator effective length (*l*), the inner and outer diameter of the stator (*Ds,Dos*), the rotor inner diameter (*Dr*), the number of effective turns per phase (*Ns*), the number of stator slots (*Qs*), the number of rotor bars *(Qr),* and the stator resistance (*Rs*). These parameters form the foundational data for all subsequent calculations.

Following the acquisition of input parameters, the method proceeds to a second step of derivation of intermediate parameters 110. In this step, the received input parameters are utilized to calculate or derive one or more intermediate parameters. These intermediate parameters, such as the winding factor (*kw*1), skewing factor (*ksq*1), slot per pole per phase (*q*), leakage factor of air gap inductance (*σδ*), various permeance factors (e.g., *λlew,λw,λu*)*,* and rotor bar length *(lbar),* are not directly provided as inputs but are useful for the accurate calculation of the final output parameters. They represent specific physical or electromagnetic characteristics derived from the basic motor geometry and winding configuration.

Subsequently, the method advances to a third step of estimation of output electrical parameters 120. In this step, the computing system estimates a set of output electrical parameters based on both the initially received specific set of input parameters and the derived intermediate parameters. The core set of output electrical parameters estimated comprises at least: an effective air gap (*δef*)*,* a magnetizing inductance (*Lm*), at least one stator leakage inductance selected from the group consisting of slot leakage inductance (*Lu*)*,* end winding leakage inductance (*Lew*), and air gap leakage inductance (*Lδ*); and a rotor resistance (*Rr*), which includes both the rotor bar resistance (*rb*) and the end ring resistance (*re*). The estimated output electrical parameters are then made available for various downstream applications 130, such as those previously mentioned.

The intermediate parameters are computationally determined using the received input parameters and are essential for the subsequent accurate estimation of the final output electrical parameters.

One intermediate parameter is the winding factor (kw1) for the fundamental component *(*v=1) of the stator winding. This factor is a product of the pitch factor (*kp*1), the distribution factor (*kd*1) and skewing factor (*ksq*1), thus *kw*1 *= kp*1 *_{*} kd*1 *_{*} ksq*1.

The pitch factor (kp1) accounts for any short-pitching of the coils. If a coil spans an angle less than a full pole pitch (180° electrical), its EMF is reduced. For a coil short-pitched by an angle *α* electrical degrees, or for a coil spanning *W* where the pole pitch is *τp*, the pitch factor for the fundamental is given by: $kp 1 = sin \left(\left(\frac{π}{2}\right)∗\left(\frac{w}{τp}\right)\right)$ or $kp 1 = cos \left(\frac{α}{2}\right)$ where *W* is the coil span (e.g., in number of slots) and *τp* is the pole pitch (e.g., in number of slots). The angle *α* represents the electrical angle by which the coil is short-pitched. The values for *W* and *τp* are derived from the input stator slot configuration *(Qs)* and pole pairs (p). For a full-pitch winding, $\frac{w}{τp} = 1$, and *kp*1 *=* 1.

The distribution factor (kd1) accounts for the distribution of winding coils in multiple slots under each pole. For a three-phase machine (m = 3), the distribution factor for the fundamental is given by: ${k}_{{d}_{1}} = \frac{sin \left(\frac{π}{6}\right)}{q ∗ sin \left(\frac{\frac{π}{6}}{q}\right)}$
*(*v = 1, *where* $\frac{π}{6}$ *corresponds to the slot angle for m* = 3*)*
where q is the number of slots per pole per phase, an intermediate parameter derived as explained below.

Another significant intermediate parameter is the skewing factor (*ksq*1) for the fundamental component (v=1). If the rotor bars (or stator slots) are skewed by an electrical angle *α_{skew},* the skewing factor is given by: ${k}_{sq 1} = \frac{sin \left(\frac{{α}_{skew}}{2}\right)}{\frac{{α}_{skew}}{2}}$ The electrical skew angle *α_{skew}* can be expressed in terms of the mechanical skew *S* (e.g., one stator slot pitch), the rotor diameter *Dr,* and the number of pole pairs *p*, or as a fraction of the pole pitch: ${α}_{skew} = p ∗ \left(\frac{2 π}{Qs}\right) ∗ {S}_{sq}$ (if *S_{sq}* is the skew in stator slot pitches, *Qs* is number of stator slots) or ${α}_{skew} = S \frac{π}{τpr}$
(if *S* is arc length of skew, *τpr* is rotor pole pitch).
The term *τpr* (rotor pole pitch) can be calculated as $τpr = π ∗ \frac{Dr}{\left(2∗p\right)}$*.*
The skew *S_{sq}* (skew in number of stator slot pitches, e.g., *S_{sq} =* 1 for one stator slot pitch skew) is a design choice that might be assumed or derived based on common practices if not an explicit input.
The intermediate parameter slot per pole per phase (q) is derived directly from the input parameters: number of stator slots *(Qs),* number of pole pairs (*p*), and number of phases (*m,* typically 3): $q = \frac{Qs}{\left(2∗p∗m\right)}$
This parameter q is used in calculating the distribution factor kd1, among other things.
The overall winding factor kw1 is then: $kw 1 = kp 1 ∗ kd 1$

The leakage factor of air gap inductance (*σδ*), also known as the air gap leakage coefficient, is useful for determining the air gap leakage inductance (*Lδ*). This dimensionless factor is derived based on characteristics of the winding arrangement, including notably the number of slots per pole per phase (*q*) and the coil span relative to the pole pitch ( $\frac{W}{τp}$). It is known that such air gap leakage factors can be ascertained from characteristic curves that are commonly found in standard technical literature and widely used motor design handbooks. These curves typically illustrate *σδ* as a function of the coil span to pole pitch ratio ( $\frac{W}{τp}$) for various values of *q* and the number of phases *m*. Therefore, for a specific motor configuration, once these characteristic winding parameters are known or derived from the input data, the value of *σδ* can be readily obtained by methods such as interpolation or direct reading from these generally available characteristic curves.

Alternatively, and also well-known in the prior art, the air gap leakage factor (*σδ*) can be calculated using analytical expressions derived from electromagnetic theory, which often involve summing the effects of various spatial harmonics of the magnetomotive force. For instance, the stator air gap leakage factor (*σδs*) is classically determined by an equation of the form: $σδs = {{\sum }_{ν \neq 1} \left(\frac{kwν}{ν ∗ kw 1}\right)}^{2}$ where the summation is performed over relevant harmonic orders *v* (*v* ≠ 1), *kwv* is the winding factor for the *v* - *th* harmonic, and *kw*1 is the winding factor for the fundamental component. Similarly, for the rotor air gap leakage factor (*σδr*), referred to the stator, established approximations considering the discrete nature of the rotor bars and fundamental current effects often take a form such as: $σδr \approx K ∗ {\left(\frac{p}{Qr}\right)}^{2}$ where *K* is a constant (e.g., $\frac{{π}^{2}}{3}$), *p* is the number of pole pairs, and *Qr* is the number of rotor bars. The specific value of *σδ* utilized as an intermediate parameter in the present method is thus determined using such established prior art techniques, whether graphical or analytical, based on the motor's input parameters and derived winding characteristics.

Various permeance factors, such as those for the end windings (*λlew,λw*) and the stator slot (*λu*), are also derived as intermediate parameters. These dimensionless factors, as previously defined, characterize the magnetic permeance of specific leakage flux paths and are useful for calculating their respective leakage inductance components.

For the stator slot permeance factor (Au), it is known in the art of electrical machine design that precise calculation often requires detailed geometric dimensions of the stator slots (such as heights and widths at various points within the slot). However, when such detailed dimensions are not available as input parameters, as is the case in the present method which relies on minimal input data, it is a common engineering practice to utilize empirically derived or typical values for *λu*. These values are often established based on observations across various motor designs and winding configurations. For instance, for common types of stator slots and winding arrangements, *λu* may be approximated to values in a range such as 1.2 to 1.35, where the specific value chosen can depend on whether the winding is full-pitch or short-pitched, reflecting general design trends.

Similarly, for the end winding permeance factors (*λlew,λw*), which are related to the calculation of end winding leakage inductance, direct calculation from first principles would require detailed knowledge of the end winding geometry (shape, length, coil span outside the core). In the absence of such detailed input, established empirical values or approximations are typically used by those skilled in the art. These values are often specific to certain classes or types of motor windings (e.g., cage rotor motors, specific winding styles). For example, for common configurations of end windings in squirrel cage induction motors, *λlew* might be approximated to a value around 0.50, and *λw* to a value around 0.20.

The use of such recognized empirical values for these permeance factors simplifies the calculation of leakage inductances when detailed geometric data of slots and end windings are not part of the minimal input set, while still providing a reasonable estimation based on common design practices.

The rotor bar length (lbar) is another geometric intermediate parameter that is derived. It represents the effective axial length of a single rotor bar. If the rotor bars are skewed, which is a common design practice to reduce noise and torque ripple, their physical length along their axis is greater than the axial length of the stator core (*l*)*.* The rotor bar length (*lbar*) is therefore calculated by considering the stator effective length (*l*), which is an input parameter, and the mechanical skew angle (*α_{skew_{mech}}*) of the rotor bars. The relationship is a standard geometric one: $lbar = \frac{l}{cos \left({α}_{{skew}_{mech}}\right)}$ The mechanical skew angle (*α_{skew_{mech}}*) itself, if not a direct input, can be determined or reasonably assumed based on common design practices. For example, rotor bars are often skewed by one stator slot pitch. In such a case, *α_{skew_{mech}}* can be related to the number of stator slots *(Qs),* an input parameter, by the formula: ${α}_{{skew}_{mech}} = {S}_{sq} ∗ \left(\frac{2 π}{Qs}\right)$ where *S_{sq}* represents the skew expressed in terms of the number of stator slot pitches (e.g., *S_{sq} =* 1 for a skew of one stator slot pitch). The accurately derived *lbar* is useful for calculating the resistance of the rotor bars and certain rotor leakage inductances.

The collective set of these derived intermediate parameters, including the winding factors, skewing factor, slots per pole per phase, air gap leakage factor, various permeance factors, and rotor bar length, along with any other necessary interim calculations, forms the refined and comprehensive basis upon which the final output electrical parameters will be estimated in the subsequent step of the method.

Following the derivation of the intermediate parameters, the method, in step 120 (Fig. 1), proceeds to estimate the set of output electrical parameters. These output parameters are calculated using the initially received specific set of input parameters and the derived intermediate parameters. This comprehensive set of output parameters characterizes the electrical behavior of the squirrel cage induction motor.

An output parameter is the effective air gap (*δef*)*.* This parameter represents the effective magnetic distance between the stator and rotor, accounting for the physical air gap, slotting effects (often quantified by Carter's coefficient), and potential magnetic saturation effects. While the precise calculation of *δef* can be complex and depend on detailed slot geometries not provided as minimal inputs, an approximation is often made by adjusting the mechanical air gap. The mechanical air gap (*δm*) can be estimated from the input parameters, for example, as half the difference between the stator inner diameter (*Ds*) and an estimated rotor outer diameter (*Dor,* which is derived from the rotor inner diameter *Dr* and assumed rotor tooth/bar heights, or simply approximated if *Dor* is considered close to *Ds* for the air gap calculation). A Carter's coefficient (*Kc*), which is typically greater than 1 and depends on slot opening to air gap ratios, is then applied: $δef = Kc ∗ δm$ The value of *Kc* can be obtained from classical design curves or formulas found in electrical machine literature if slot opening dimensions are assumed or typical values are used. Alternatively, *δef* may be an iteratively refined parameter or determined using a specific empirical or semi-empirical formula developed for this estimation method, which utilizes the available minimal input data to approximate these combined effects. An accurately determined *δef* is useful for the subsequent calculation of the magnetizing inductance.

The magnetizing inductance (*Lm*) is a cornerstone output parameter representing the mutual flux linkage in the motor. It is calculated using several input and intermediate parameters. A common formula for *Lm* is: $Lm = \left(\frac{m}{2}\right) ∗ \frac{μ 0 ∗ Dδ ∗ leq ∗ {\left(Ns∗kw1\right)}^{2}}{π ∗ {p}^{2} ∗ δef}$ where:
- *m* is the number of phases (input parameter).
- *µ*0 is the permeability of free space (a known physical constant).
- *Dδ* represents the mean air gap diameter, which can be approximated from the stator inner diameter (*Ds*) and the effective air gap (*δef*)*,* for instance, *Dδ* ≈ *Ds - δef.*
- *leq* is the equivalent core length, taken as the stator effective length (*l*) (input parameter).
- *Ns* is the number of effective turns per phase (input parameter).
- *kw*1 is the fundamental winding factor (derived intermediate parameter).
- *p* is the number of pole pairs (input parameter).
- *δef* is the effective air gap (output parameter, as determined above).

At least one stator leakage inductance is estimated. The method provides for the estimation of several components which contribute to the overall stator leakage.

The slot leakage inductance (*Lu*), arising from magnetic flux confined within the stator slots, is calculated as: $Lu = \left(\frac{4 ∗ m}{Qs}\right) ∗ μ 0 ∗ l ∗ {\left(Ns per slot series\right)}^{2} ∗ λu$ where *m, Qs, µ*0*, l* are as previously defined or are input parameters. *Ns per slot series* represents the number of turns in series per stator slot for one phase, which can be derived from *Ns* (total turns per phase) and the winding layout (e.g., $\frac{Ns}{\left(p∗q\right)}$ if *q* is slots per pole per phase). *λu* is the stator slot permeance factor (derived intermediate parameter, e.g., a typical empirical value between 1.2 and 1.35).

The end winding leakage inductance (Lew), due to flux around the portions of windings outside the stator core, is calculated using the derived end winding permeance factors and geometric approximations for the end winding dimensions:$Lew = \left(\frac{4 ∗ m}{Qs}\right) ∗ μ 0 ∗ q ∗ {\left(Ns per slot series\right)}^{2} ∗ \left(2∗{lew}_{geom}∗λlew+{Wew}_{geom}∗λw\right)$ where *q* is the slots per pole per phase (intermediate parameter), *Ns per slot series* is as above. *lew_{geom}* and *Wew_{geom}* are characteristic geometric dimensions of the end winding (axial length and coil span outside the core), which are themselves intermediate parameters often approximated from the pole pitch (*τp*) and stator diameter (*Ds*) (e.g., *Wew_{geom}* ≈ *(CoilPitchFactor) _{*} τp,* and *lew_{geom}* ≈ *C_{ewₗ *} Wew_{geom}* where *C_{ewₗ}* is an empirical ratio like 0.35). *λlew* and *λw* are the end winding permeance factors (derived intermediate parameters, e.g., typical empirical values like 0.50 and 0.20).

The air gap leakage inductance (*Lδ*), associated with harmonic fluxes in the air gap not contributing to the main mutual flux, is calculated as: $Lδ = σδ ∗ Lm$ where *σδ* is the leakage factor of air gap inductance (derived intermediate parameter) and *Lm* is the magnetizing inductance (output parameter, calculated above).

The rotor resistance (Rr), as referred to the stator side, is another critical output parameter. Its estimation involves determining the resistance of the rotor bars (*rb*) and end rings (*re*)*.* The resistance of a single rotor bar (*rb*) is calculated as: $rb = {ρ}_{rotor} ∗ \frac{lbar}{{A}_{bar}}$ where *ρᵣₒₜₒᵣ* is the resistivity of the rotor bar material (e.g., aluminum or copper, which is a known material property or an assumed typical value if not an input), *lbar* is the derived rotor bar length (intermediate parameter), and *A_{bar}* is the cross-sectional area of a rotor bar. *A_{bar}* itself must be estimated, as detailed slot/bar dimensions are not direct inputs. This estimation can be based on the number of rotor bars (*Qr*), the rotor diameter (*Dr*), and assumptions about slot fill factor or typical bar dimensions for the class of motor.
The resistance of an end ring segment (*re*) associated with one bar is often approximated as a fraction of the bar resistance, or calculated based on an estimated end ring cross-sectional area (*Aₑᵣ*) and mean path length:
*re* ≈ (0.01 *to* 0.05) _{*} *rb* (empirical approximation if detailed geometry is unknown)
or $re = {ρ}_{rotor} ∗ \frac{\left(π∗\frac{{D}_{{er}_{mean}}}{Qr}\right)}{{A}_{er}}$ where *D_{erₘₑₐₙ}* is the mean diameter of the end ring.
Once *rb* and *re* are determined, the equivalent resistance of one phase of the Qr-phase rotor cage (*Rr_{phasecage}*) is: ${Rr}_{phasecage} = rb + \frac{re}{2 ∗ {sin}^{2} \left(p∗\frac{π}{Qr}\right)}$
Finally, this rotor cage phase resistance is referred to the stator to obtain *Rr*: $Rr = {K}_{ref} ∗ {Rr}_{phasecage}$ where *K_{ref}* is a referral factor that includes the number of stator phases (*m*), number of rotor bars (*Qr*), effective stator turns per phase (*Ns*), stator winding factor (*kw*1)*,* and rotor skew factor (*ksq*1*r,* the rotor equivalent of *ksq*1)*.* A common form for *K_{ref}* is $\frac{\left(2∗m∗{\left(Ns∗kw1\right)}^{2}\right)}{\left(Qr∗ksq1{r}^{2}\right)}$ or similar, depending on the specific equivalent circuit conventions.

The method may further estimate the total stator leakage inductance (*Lls*) and total rotor leakage inductance (*Llr*) (referred to the stator).
The total stator leakage inductance (*Lls*) is commonly taken as the sum of its principal components: $Lls \approx Lu + Lew + Lδ$ The total rotor leakage inductance (*Llr*), referred to the stator, is similarly derived from its components, primarily the bar leakage inductance (*Lb*) and end ring leakage inductance (*Le*), after appropriate referral to the stator. It can also be estimated in relation to the stator leakage inductance, for example, *Llr* ≈ *Lls* is a common first approximation in some contexts if detailed rotor leakage calculations are not performed. Alternatively, *Llr* is calculated from rotor-side leakage components *Lb* and *Le* using a referral factor similar to that used for *Rr*.

The method may further estimate stator total inductance (*Ls*) and rotor total inductance (*Lr*) (referred to the stator). These are calculated by adding the respective leakage inductances to the magnetizing inductance: $Ls = Lm + Lls$ $Lr = Lm + Llr$ (using *Lm* as seen from the stator for both)

The method may further estimate the specific rotor leakage components: bar leakage inductance (*Lb*) and end ring leakage inductance (*Le*)*.*
The calculation of *Lb* requires estimation of the permeance associated with flux paths around a rotor bar within its slot. This would involve assumptions about rotor slot geometry (similar to *λu* for the stator) and the application of standard formulae for slot leakage.
The calculation of *Le* involves the geometry of the end rings. A known formula, for example by Levi, can be used: ${Le}_{rotorside} = \left(\frac{Qr}{\left({m}_{rotorequiv}∗{p}^{2}\right)}\right) ∗ \left(\frac{μ 0}{3}\right) ∗ \left(\left(lbar-{l}_{equivstator}\right)+{v}_{factor}∗\left(π∗\frac{{D}_{{er}_{mean}}}{\left(2∗p\right)}\right)\right)$ where *m_{rotorequív}* is an equivalent number of rotor phases (often *Qr*)*, l_{equivstator}* is an equivalent stator length, and *v_{factor}* is an empirical coefficient. This *Le_{rotorside}* would then need to be referred to the stator.

As previously discussed, the estimated rotor resistance (*Rr*) fundamentally comprises the bar resistance (*rb*) and end ring resistance (*re*), the calculation methods for which have been outlined previously. The clear distinction and calculation of *rb* and *re* allow for a more detailed analysis of rotor losses and potential fault conditions.

The comprehensive set of estimated output electrical parameters, whether the principal set or the extended set including these supplementary parameters, thus provides a detailed and accurate characterization of the specific physical induction motor. This detailed characterization, derived from a minimal set of easily obtainable input data, enables the advanced downstream applications, such as improved predictive maintenance, high-fidelity digital twinning, accurate fault simulation, and advanced motor modeling.

As previously indicated, the estimation of said set of output electrical parameters, particularly the various inductances such as magnetizing inductance (*Lm*) and leakage inductances (*Lu,Lew,Lδ,Lls,Llr,Lb,Le*)*,* is based, at least in part, on principles derived from or consistent with the Modified Winding Function Method (MWFM). The MWFM, as known in the art of electrical machine analysis, is an advanced analytical technique for calculating the inductances of electrical machines by considering the detailed spatial distribution of stator and rotor windings and the geometry of the air gap.

The fundamental principle of the Winding Function Method (WFM), from which the MWFM is derived, involves defining a "winding function" for each winding. This function describes the magnetomotive force (MMF) distribution produced by that winding along the air gap periphery when it carries a unit current. The self-inductance of a winding, or the mutual inductance between two windings, can then be calculated by integrating the product of the relevant winding function(s) and the air gap permeance function (or its inverse, the reluctance function) over the air gap circumference.

The "Modified" aspect of MWFM typically incorporates refinements to the classical WFM to provide more accurate results by better accounting for complex physical phenomena. These modifications may include, for example:
- Improved representation of the air gap permeance, considering the effects of stator and rotor slot openings (e.g., using Carter's coefficients or more detailed permeance wave calculations) to accurately model the effective air gap (*δef*)*.*
- Techniques to account for magnetic saturation in the iron core, which can affect inductances, although the present method primarily aims for estimation from minimal data which may not include detailed B-H curves for saturation modeling.
- Consideration of skewing effects, not just as a simple factor (*ksq*1)*,* but potentially by integrating the winding functions along the skewed path of the conductors.
- More detailed calculation of harmonic leakage inductances by analyzing the interaction of higher-order MMF harmonics produced by the winding distributions.

In the context of the present invention, which aims to estimate parameters from a minimal set of input data, the direct application of a full, detailed MWFM requiring all intricate geometric details (like precise slot shapes for permeance calculations) might not be feasible. However, the underlying equations and approaches used for calculating inductances, such as those presented for *Lm,Lu,Lew,* and *Lδ,* are derived from or are consistent with the foundational principles of the MWFM. For example, the calculation of *Lm* explicitly uses the effective air gap (*δef*) and the winding factor (kw1), which are key components in MWFM-based inductance calculations. Similarly, the calculation of leakage inductances often involves permeance factors (*λu,λlew,λw*) which are simplified representations of what would be more complex permeance functions in a full MWFM.

Therefore, by stating that the estimation is based at least in part on the MWFM, it is understood that the analytical framework and the physical understanding of how winding distributions and air gap geometry determine inductances, as captured by the MWFM, inform the structure of the equations and the choice of intermediate parameters used in the present method. This ensures that the estimated inductances are physically meaningful and derived from a sound theoretical basis, even when certain detailed inputs are approximated or represented by typical empirical values due to the minimal input data constraint. The method essentially leverages simplified or empirically-informed versions of MWFM concepts to achieve accurate estimations without requiring the full complexity of a complete MWFM implementation from scratch which would demand far more input detail.

The present document also relates to a system configured to implement the method for estimating electrical parameters of a squirrel cage induction motor as described above. Referring now to Fig. 2, a schematic block diagram illustrating an embodiment of such an estimation system 200 is shown.

The system 200 comprises an input interface 210. The input interface 210 is configured to receive the specific set of input parameters for the squirrel cage induction motor that is to be characterized. These input parameters are those previously detailed, comprising at least the number of phases (*m*), pole pairs (*p*), stator effective length (*l*), inner and outer diameter of the stator (*Ds,Dos*), rotor inner diameter (*Dr*), number of effective turns per phase (*Ns*), number of stator slots (*Qs*), number of rotor bars (*Qr*), and stator resistance (*Rs*). The input interface 210 can be realized in various ways, for example, as a graphical user interface (GUI) for manual data entry by an operator, a file reader for importing parameters from a data file (e.g., a spreadsheet or text file), a network connection for receiving parameters from a remote database or another system, or an application programming interface (API) for programmatic input.

The system 200 further comprises a processor 220. The processor 220 is communicatively coupled to the input interface 210, typically via an internal bus or direct connection, to receive the input parameters. The processor 220 may be any suitable processing device, such as one or more central processing units (CPUs), microprocessors, digital signal processors (DSPs), application-specific integrated circuits (ASICs), or field-programmable gate arrays (FPGAs), capable of executing programmed instructions. The processor 220 is responsible for performing all the computational tasks of the estimation method.

Communicatively coupled to the processor 220 is a memory 230. The memory 230 is a non-transient computer-readable storage medium that stores data and program instructions. Specifically, the memory 230 stores a set of instructions which, when executed by the processor 220, cause the system 200 to perform the steps of the method for estimating electrical parameters as described in detail above. These steps include receiving the specific set of input parameters via the input interface 210, deriving the one or more intermediate parameters using said input parameters, and subsequently estimating the set of output electrical parameters based on said input parameters and said derived intermediate parameters. The memory 230 may also be used by the processor 220 for temporary storage of the input parameters, intermediate parameters, output parameters, and any other data required during the execution of the method. The memory 230 can encompass various types of storage, such as RAM for active operations and ROM, flash memory, or a hard disk for persistent storage of the instructions.

Optionally, the system 200 may also comprise an output interface 240 (not explicitly shown in all embodiments of Fig. 2 but understood to be present for practical use). The output interface 240 would be communicatively coupled to the processor 220 and configured to present or transmit the estimated set of output electrical parameters. This could involve displaying the parameters on a screen, writing them to a file, transmitting them over a network to another system (e.g., a predictive maintenance platform or a digital twin environment), or making them available via an API.

## Claims

1. A method for estimating electrical parameters of a squirrel cage induction motor using a computing system, the method comprising:
- receiving (100) a specific set of input parameters for the squirrel cage induction motor, said specific set of input parameters comprising: number of phases (*m*); pole pairs (*p*); stator effective length (*l*); inner and outer diameter of the stator (*Ds,Dos*); rotor inner diameter (*Dr*); number of effective turns per phase (*Ns*); number of stator slots (*Qs*); number of rotor bars (*Qr*); and stator resistance (*Rs*);
- deriving (110) from said specific set of input parameters, one or more intermediate parameters; and
- estimating (120), based on said specific set of input parameters and the derived intermediate parameters, a set of output electrical parameters for the squirrel cage induction motor, said output electrical parameters comprising: an effective air gap (*δef*); a magnetizing inductance (*Lm*); at least one stator leakage inductance selected from the group consisting of slot leakage inductance (*Lu*), end winding leakage inductance (*Lew*), and air gap leakage inductance (*Lδ*); and a rotor resistance (*Rr*).

2. The method according to the preceding claim, wherein the one or more intermediate parameters derived from said specific set of input parameters comprise at least one selected from the group consisting of: a winding factor (kw1); a skewing factor (*ksq*1); a slot per pole per phase (*q*); a leakage factor of air gap inductance (*σδ*); permeance factors of windings (*λlew,λw*) and stator slot (*λu*); and a rotor bar length (*lbar*)*.*

3. The method according to any of the preceding claims, wherein the set of output electrical parameters estimated based on said specific set of input parameters and the derived intermediate parameters further comprises at least one selected from the group consisting of: stator and rotor leakage inductances (*Lls,Llr);* stator and rotor total inductances (*Ls,Lr);* bar leakage inductance (*Lb*); and end ring leakage inductance *(Le).*

4. The method according to any of the preceding claims, wherein the rotor resistance (Rr) estimated based on said specific set of input parameters and the derived intermediate parameters comprises bar resistance *(rb)* and end ring resistance *(re).*

5. The method according to any of the preceding claims, wherein the estimation of said set of output electrical parameters is based at least in part on a Modified Winding Function Method (MWFM).

6. The method according to any of the preceding claims, wherein the method further comprises:
- controlling the operation of said physical squirrel cage induction motor using a variable speed drive (VSD), wherein at least one control parameter of said VSD is determined or adjusted based on at least one of the estimated output electrical parameters; or
- performing a maintenance action on said physical squirrel cage induction motor, wherein the decision to perform said maintenance action, or the nature of said maintenance action, is determined based on an analysis of the condition of said motor, said analysis utilizing at least one of the estimated output electrical parameters to model or assess said condition; or
- modifying an operational characteristic or a maintenance schedule of said physical squirrel cage induction motor, wherein said modification is determined based on an assessment utilizing at least one of the estimated output electrical parameters; or
- providing said estimated set of output electrical parameters to a motor control system or a predictive maintenance system; and said motor control system or said predictive maintenance system subsequently initiating an action affecting said physical squirrel cage induction motor or its operational environment based on said estimated parameters.

7. A system (200) for estimating electrical parameters of a squirrel cage induction motor, the system comprising:
- an input interface (210) configured to receive a specific set of input parameters for the squirrel cage induction motor, and
- a memory (230) communicatively coupled to the processor (220), the memory (230) storing instructions that, when executed by the processor (220), cause the system to perform the method according to any of the preceding claims.

8. A computer program product comprising instructions which, when the program is executed by a computer, cause the computer to carry out the method of any of claims 1 to 6.

9. A non-transient computer-readable storage medium storing instructions thereon that, when executed by one or more processors, cause the one or more processors to perform the method of any of claims 1 to 6.
